# FASCICULE DE BREVET EUROPEEN

(11) **EP 0 321 327 B1**
(45) Date de publication et mention de la délivrance du brevet: **10.04.1996**
(21) Numéro de dépôt: 88403140.2
(22) Date de dépôt: 09.12.1988
(51) Int. Cl.: H01L 23/14, G06K 19/06

(54) **Procédé de mise en place d'un composant électronique et de ses connexions électriques sur un support**
Verfahren zum Plazieren einer elektronischen Komponente und seiner elektronsichen Verbindungen auf einer Unterlage
Method of mounting an electronic component and its electronic connections on a support

(30) Priorité: 14.12.1987 FR 8717386
(43) Date de publication de la demande: 21.06.1989
(73) Titulaire: SGS-THOMSON MICROELECTRONICS S.A., F-94250 Gentilly (FR)
(72) Inventeur: Gloton, Jean-Pierre, F-75116 Paris (FR); Coiton, Gérard, F-75116 Paris (FR)
(74) Mandataire: Ballot, Paul Denis Jacques

(56) Documents cités:
- EP-A- 0 128 822
- PATENT ABSTRACTS OF JAPAN vol. 9, no. 244 (E-346)(1967), 30 septembre 1985; & JP-A-60 95941
- PATENT ABSTRACTS OF JAPAN vol 10, no. 162 (P-466)(2218), 10juin 1986; & JP-A61 15289

## Description

L'invention concerne un procédé de mise en place d'un composant électronique et de ses connexions électriques sur un support tel qu'une carte d'identification ou une carte bancaire ; elle concerne également le produit obtenu en mettant en oeuvre ce procédé.

Il est connu d'utiliser des cartes d'identification dans de nombreux domaines notamment dans celui des cartes bancaires ou de crédit. Pendant très longtemps, ces cartes ne comportèrent, outre un numéro d'identification et le nom du titulaire, un enregistrement magnétique qui en permettait l'identification par lecture magnétique. Depuis quelques années, ces cartes sont utilisées à des fonctions autres que l'identification du titulaire et notamment à des fins de pré-payement et de protection contre les actions des fraudeurs. A cet effet, la carte comporte un composant électronique actif qui peut être constitué d'une mémoire électronique associée ou non à un microprocesseur, ce qui permet de l'utiliser notamment pour des applications de type bancaire.

Les cartes de l'état de la technique qui comportent un composant électronique sont fabriquées de diverses manières. Dans un premier procédé, une cavité est aménagée dans l'épaisseur de la carte pour recevoir le composant électronique. Dans un autre procédé dit de "co-laminage", on lamine de fines couches de matière plastique : polyépoxy, polyéthylène, polychlorure de vinyl etc... autour du composant. Lors de la mise en oeuvre de ces procédés, diverses opérations sont en outre effectuées pour assurer la connexion électrique des bornes du composant électronique à des métallisations qui sont disposées en surface sur la carte.

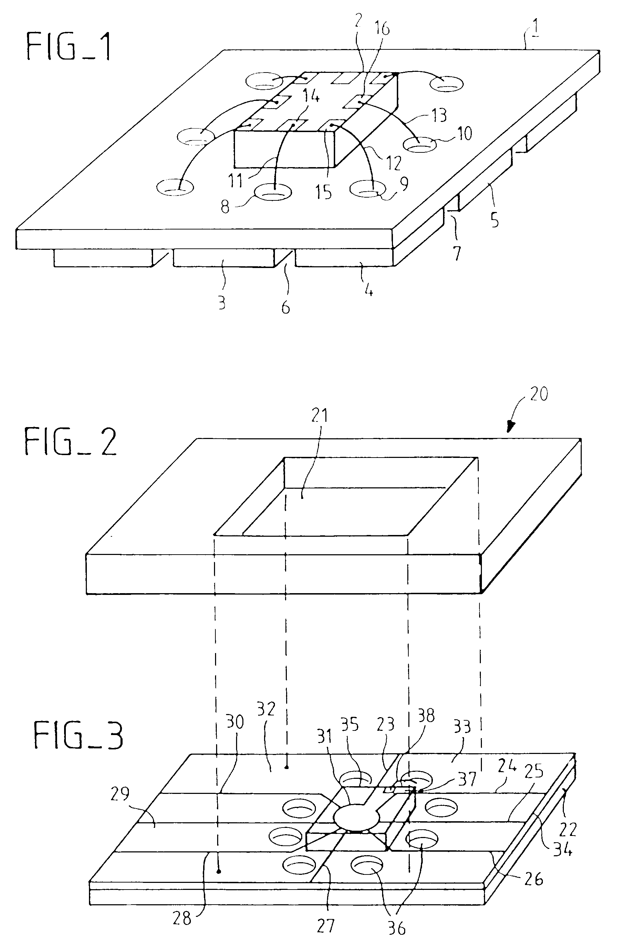

L'un des procédés pour mettre en place le composant électronique dans la cavité aménagée dans la carte et pour disposer les métallisations sur la carte ainsi que pour réaliser les connexions entre les bornes de la carte et les métallisations consiste, comme le montre la figure 1, à utiliser un film 1 non conducteur, par exemple en polyépoxy, qui porte, d'un côté, le composant électronique sous forme d'une puce référencée 2 et, de l'autre côté, des surfaces métallisées telles que celles référencées 3, 4 et 5 et séparées les unes des autres par des espaces 6 et 7 sans métallisation. Ces surfaces métallisées 3, 4 et 5 communiquent avec l'autre côté du film 1 par des trous 8, 9 et 10 par l'intermédiaire desquels les extrémités de fils conducteurs 11, 12 et 13 viennent se connecter aux surfaces métallisées correspondantes par tous moyens connus tels qu'une colle conductrice. L'autre extrémité de chaque fil conducteur est connectée à une borne de sortie 14, 15 ou 16 de la puce 2. Un tel procédé est connu de EP-A-0 128 822.

Ces opérations sont ensuite suivies de l'enrobage de la puce 2 avec de la résine et d'une cuisson de la résine pour obtenir l'encapsulation de la puce. On peut alors mettre en place la puce dans la cavité de la carte et disposer les métallisations sur les bords de la cavité par simple emboîtage de la puce et collage du film support 1 sur la carte après son découpage aux dimensions requises.

Le procédé qui vient d'être décrit succinctement ci-dessus présente l'inconvénient que le film 1 et la colle qui est utilisée pour maintenir les métallisations 3, 4 et 5 ne peuvent supporter des températures supérieures à 150°C et il en résulte un allongement considérable du temps de cuisson de la résine qui sert à encapsuler la puce 2, ce qui est coûteux, notamment dans une chaîne de fabrication automatique.

Le but de la présente invention est donc de remédier aux inconvénients précités en mettant en oeuvre un procédé de mise en place d'un composant électronique et de ses connexions électriques sur un support qui permet une plus haute température de cuisson de la résine d'enrobage, d'où un temps de cuisson plus faible et donc un coût moins élevé.

L'invention se rapporte à un procédé de mise en place d'un composant électronique et de ses connexions électriques sur un support comportant une cavité pour loger ledit composant, comportant la séquence des opérations suivantes :
a) le dépôt sur un support de travail tel qu'une plaquette, d'une couche métallique,
b) le découpage de cette couche métallique en zones isolées électriquement l'une de l'autre,
c) le dépôt sur une face de ces zones métalliques d'une couche de polyimide,
d) le collage sur l'autre face de ces zones métalliques du composant électronique comportant des bornes de sortie,
e) le raccordement électrique des bornes de sortie du composant électronique aux zones métalliques,
f) l'enrobage du composant électronique et des connexions électriques par une résine,
g) le chauffage de l'ensemble constitué de la couche de polyimide, la couche métallique portant le composant électronique et les connexions électriques enrobés par la résine, à température élevée, de manière à obtenir rapidement le durcissement de la résine,
h) la mise en place de l'ensemble sur le support de manière que le composant électronique encapsulé se loge dans la cavité.

L'invention se rapporte également à un produit obtenu en mettant en oeuvre le procédé qui comprend une carte support munie d'une cavité et un composant électronique disposé dans ladite cavité, caractérisé en ce que ledit composant électronique est disposé directement sur une couche métallique, qui est collée sur la carte, et que cette couche métallique est divisée en zones correspondant chacune à un contact.

Dans une variante du procédé, le produit obtenu présente un composant électronique qui est fixé sur la couche métallique par l'intermédiaire d'une couche de polyimide.

D'autres caractéristiques et avantages de la présente invention apparaîtront à la lecture de la description suivante d'un exemple particulier de réalisation, ladite description étant faite en relation avec le dessin joint dans lequel :
- la figure 1 est une vue en perspective cavalière d'un film de support de composant électronique et de ses connexions électriques mettant en oeuvre un procédé selon l'art antérieur,
- la figure 2 est une vue en perspective cavalière d'une carte mémoire prévue pour recevoir un composant électronique,
- la figure 3 est une vue en perspective cavalière d'un composant électronique disposé sur une couche métallique du support, mettant en oeuvre le procédé selon l'invention, et
- la figure 4 est une vue en perspective d'un autre mode de réalisation de l'invention.

La figure 1 correspond à l'art antérieur et a été décrite dans le préambule. Sur la figure 2, on a représenté une carte mémoire 20 qui comporte en son milieu une cavité 21 dans laquelle doit venir se loger un composant électronique, par exemple la puce 2 de la figure 1. Dans le procédé de l'art antérieur pour mettre en place la puce dans son logement, il faut bien entendu présenter le film 1 sens dessus-dessous par rapport à la carte 20 de manière que la puce 2 s'emboîte dans la cavité 21.

Selon l'invention, on remplace le film support 1 par une couche de métal 22, par exemple du cuivre ou du nickel, ayant une épaisseur de quelques dizaines de microns, par exemple quatre-vingt microns. Cette couche métallique 22, déposée sur un support de travail non représenté, est découpée selon le tracé qui est indiqué par les segments 23 à 30 reliés au centre par une découpe circulaire 31. Cette découpe peut être effectuée par tous moyens connus et notamment par un procédé chimique tel que la gravure ou un procédé mécanique mettant en oeuvre un dispositif laser.

Ces différents segments 23 à 31 délimitent des zones métalliques telles que celles référencées 32 et 33, qui sont séparées électriquement de manière à faire office de contacts. Pour que ces différentes zones ne se séparent pas les unes des autres, on dépose sur toute leur surface une couche 34 de polyimide ou de silicone. Ce dépôt est effectué en phase liquide sur le métal et adhère naturellement sur ce dernier sans modifier la structure du métal et des zones métalliques. A la place du polyimide ou de silicone, on peut utiliser de la résine époxy qui est déposée à très haute température. L'épaisseur de cette couche de polyimide est de quelques microns environ, par exemple trois microns. Sur la figure 3, cette couche de polyimide est supposée transparente.

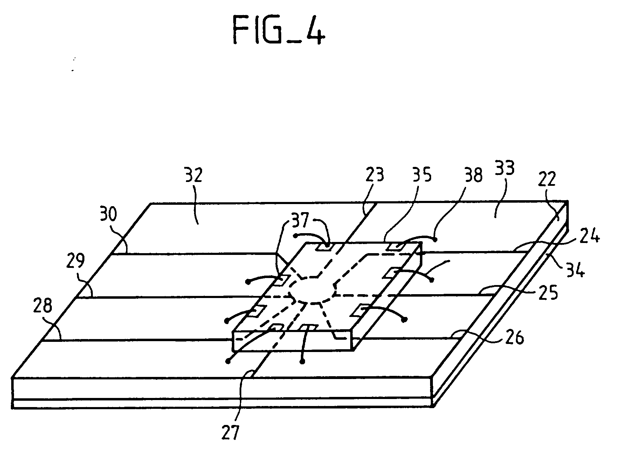

L'opération suivante consiste à poser et coller un composant électronique 35 sur la couche métallique 22. A cet effet, deux solutions sont possibles : l'une est de retourner l'ensemble -zones métalliques, couche de polyimide- pour que la couche de polyimide 34 soit en contact avec le support de travail (figure 4), l'autre est d'enlever la couche de polyimide à l'endroit où le composant 35 doit être collé par tous procédés connus, par exemple par attaque chimique avec masque. Dans cette deuxième solution, le masque est prévu pour enlever la couche de polyimide, non seulement à l'endroit du composant 35, mais aussi aux endroits 36 où les connexions électriques entre le composant et les zones métalliques doivent être effectuées. Lorsque la zone du composant a été dégagée dans la couche de polyimide, le composant 35 est collé sur ladite zone à l'aide d'une colle qui résiste aux hautes températures.

Cette opération de collage du composant 35 est suivie d'une opération de raccordement électrique de chacune des bornes de sortie 37 de la puce 35 à une zone métallique 32 par l'intermédiaire d'un fil conducteur 38. Le raccordement des extrémités de chaque fil conducteur peut être effectué par tous moyens connus, par exemple par collage à l'aide d'une colle conductrice.

A ce stade du procédé, l'ensemble -couche de polyimide 34 et couche métallique 22 portant le composant électronique 35 et les connexions électriques 38- est prêt pour effectuer l'opération d'encapsulation du composant électronique 35 et des connexions électriques par tous procédés connus, notamment le moulage dans une résine puis chauffage de l'ensemble pour durcir la résine et obtenir un bloc compact (non représenté). Du fait de l'absence d'un film support de la couche métallique et d'une colle de maintien entre cette couche métallique et le film support, éléments qui ne résistent pas à des températures supérieures à 150°C, l'ensemble de chacune des figures 3 et 4 peut être chauffé à des températures voisines de 300°C, ce qui accélère considérablement le processus de durcissement de la résine d'encapsulation. Il en résulte une chaîne de fabrication automatique plus simple et un gain de temps et d'argent.

Lorsque l'opération d'encapsulation est terminée, l'ensemble composant-couche métallique est mis en place sur la carte 20 (figure 2) de manière que le bloc compact contenant le composant 35 et ses connexions électriques s'emboîte dans la cavité 21 et que les zones métalliques viennent reposer sur les bords de la cavité où ils sont fixés par tous procédés connus, notamment par collage. On remarquera que ces zones métalliques reposent directement sur les bords de la cavité 21 dans le cas de la figure 4 mais par l'intermédiaire de la couche de polyimide 34 dans le cas de la figure 3.

Dans le cas de la figure 4, comme la couche de polyimide 34 rencontre le côté extérieur des zones métalliques après mise en place sur la carte, cette couche doit être enlevée pour dégager les zones métalliques de manière qu'elles jouent leur rôle de contacts électriques. Cet enlèvement peut être effectué par tous procédés connus, par exemple par attaque chimique sans masque, soit encore par un procédé mécanique tel que le polissage.

Dans le cas de la figure 3, il est également prévu d'enlever les bavures de polyimide qui peuvent s'être formées sur le côté des zones métalliques opposé à celui de la couche de polyimide. Cette opération de nettoyage peut être effectuée avant ou après la mise en place de l'ensemble composant-couche métallique sur la carte. Dans ce nettoyage, il convient de ne pas abîmer la couche de polyimide sous-jacente 34.

Lors de cette opération d'enlèvement de la couche de polyimide ou de ses bavures sur le côté opposé, le polyimide occupant les espaces entre les zones métalliques est également retiré, de sorte que lesdites zones apparaissent en relief sur le centre du support 20 et qu'il peut exister des trous de communication entre la cavité 21 et l'environnement extérieur à la carte. Pour éviter ces trous, il est prévu que l'encapsulation conduise à une capsule de dimensions aussi proches que possible de celles de la cavité. Il peut également être prévu de laisser en place le polyimide entre les zones métalliques, ce qui signifie qu'il ne faut pas utiliser une attaque chimique pour l'enlèvement du polyimide mais un polissage mécanique.

Dans le cas du procédé correspondant à la figure 3, la couche de polyimide 34 reste en place dans le dispositif final. Selon une variante du procédé, elle peut être enlevée avant la mise en place de l'ensemble sur la carte mais, dans ce cas, il faut tenir compte que la tenue mécanique des zones métalliques est moins bonne. Pour remédier à ce problème, il est proposé de laisser en place les joints de polyimide entre lesdites zones et de remplacer la couche de polyimide par une couche de colle qui sert à fixer l'ensemble sur la carte.

## Revendications

1. Procédé de mise en place d'un composant électronique (35) et de ses connexions électriques (32, 38) sur un support (20) comportant une cavité (21) pour loger ledit composant, ledit procédé comprenant la séquence des opérations suivantes :
a) le dépôt sur un support de travail tel qu'une plaquette d'une couche métallique (22),
b) le découpage de cette couche métallique (22) en zones (32) isolées électriquement l'une de l'autre,
c) le dépôt sur une face de ces zones métalliques d'une couche de polyimide (34),
d) le collage sur l'autre face de ces zones métalliques du composant électronique (35) comportant des bornes de sortie (37),
e) le raccordement électrique de ces bornes de sortie (37) du composant électronique (35) aux zones métalliques (32),
f) l'enrobage du composant électronique et des connexions électriques (38) par une résine,
g) le chauffage de l'ensemble constitué de la couche de polyimide (34), la couche métallique (22) portant le composant électronique (35) et les connexions électriques (38) enrobés par la résine, à température élevée, de manière à obtenir rapidement le durcissement de la résine,
h) la mise en place de l'ensemble sur le support (20) de manière que le composant électronique encapsulé se loge dans la cavité (21).

2. Procédé selon la revendication 1, caractérisé en ce qu'il comprend l'opération supplémentaire suivante :
i) l'enlèvement de la couche de polyimide (34) de manière à dégager les zones métalliques (32) sans altérer les joints de polyimide entre les zones métalliques (23 à 39).

3. Procédé selon la revendication 2, caractérisé en ce que l'opération d'enlèvement de la couche de polyimide (34) est prévue pour enlever également les joints de polyimide entre les zones métalliques (23 à 31).

4. Procédé de mise en place d'un composant électronique (35) et de ses connexions électriques (32,38) sur un support (20) comportant une cavité (21) pour loger ledit composant, ledit procédé comprenant la séquence des opérations suivantes :
a) le dépôt sur un support de travail tel qu'une plaquette d'une couche métallique (22),
b) le découpage de cette couche métallique (22) en zones (32) isolées électriquement l'une de l'autre,
c) le dépôt sur une face de ces zones métalliques d'une couche de polyimide (34),
d) l'enlèvement de la couche de polyimide au moins aux endroits (36) des zones métalliques (32) prévus pour effectuer les connexions électriques et à l'endroit où le composant électronique (35) doit être collé,
e) le collage du composant électronique (35) comportant des bornes de sorties (37) sur ladite face,
f) le raccordement électrique de ces bornes de sortie (37) du composant électronique (35) aux zones métalliques (32),
g) l'enrobage du composant électronique et des connexions électriques (38) par une résine,
h) le chauffage de l'ensemble constitué de la couche de polyimide (34), la couche métallique (22) portant le composant électronique (35) et les connexions électriques (38) enrobés par la résine, à température élevée, de manière à obtenir rapidement le durcissement de la résine,
i) la mise en place de l'ensemble sur le support (20) de manière que le composant électronique se loge dans la cavité (21).

5. Procédé selon la revendication 4, caractérisé en ce que l'opération de mise en place de l'ensemble sur le support (20) est précédée d'une opération d'enlèvement de la couche de polyimide (34) sans altérer les joints de polyimide entre les zones métalliques (23 à 31).

6. Procédé selon l'une quelconque des revendications précédentes dans lequel le polyimide est remplacé par du silicone et/ou de la résine epoxy.

## Patentansprüche

1. Verfahren zum Plazieren einer elektronischen Komponente (35) und seiner elektrischen Verbindungen (32, 38) auf einen Träger (20), der eine Ausnehmung (21) zum Einbringen dieser Komponente aufweist, wobei dieses Verfahren die folgenden Arbeitsgänge aufweist:
a) Aufbringen einer Metallschicht (22) auf einen Arbeitsträger, beispielsweise einer Platte,
b) Zerschneiden der Metallschicht (22) in gegeneinander elektrisch isolierte Zonen (32),
c) Aufbringen einer Schicht aus Polyimid (34) auf eine Fläche dieser metallischen Zonen,
d) Aufkleben der elektronischen Komponente (35), die die Ausgangsanschlüsse (37) aufweist, auf die andere Fläche der metallischen Zonen,
e) elektrisches Verbinden der Ausgangsanschlüsse (37) der elektronischen Komponente (35) mit den metallischen Zonen (32),
f) Einbetten der elektronischen Komponente und der elektrischen Verbindungen (38) mittels eines Harzes,
g) Erhitzen der Anordnung, bestehend aus der Polyimid-Schicht (34) der Metallschicht (22), die die elektronische Komponente (35) und die elektrischen Verbindungen (38) trägt, die in dem Harz eingebettet sind, auf eine erhöhte Temperatur derart, daß ein schnelles Aushärten des Harzes erzielt wird,
h) Plazieren der Anordnung auf den Träger (20) derart, daß die eingekapselte elektronische Komponente in der Ausnehmung (21) liegt.

2. Verfahren nach Anspruch 1, **dadurch gekennzeichnet**, daß es folgenden zusätzlichen Arbeitsgang umfaßt:
i) Beseitigen der Polyimid-Schicht (34) derart, daß die metallischen Zonen (32) freigelegt werden, ohne die Verbindungen des Polyimids zwischen den metallischen Zonen (23 bis 39) zu verändern.

3. Verfahren nach Anspruch 2, **dadurch gekennzeichnet**, daß der Arbeitsgang des Beseitigens der Polyimid-Schicht (34) vorgesehen ist, um auch die Polyimid-Verbindungen zwischen den metallischen Zonen (23 bis 31) zu beseitigen.

4. Verfahren zum Plazieren einer elektronischen Komponente (35) und seiner elektrischen Verbindungen (32, 38) auf einen Träger (20), der eine Ausnehmung (21) zum Einbringen dieser Komponente aufweist, wobei dieses Verfahren die folgenden Arbeitsgänge aufweist:
a) Aufbringen einer Metallschicht (22) auf einen Arbeitsträger, beispielsweise einer Platte,
b) Zerschneiden der Metallschicht (22) in gegeneinander elektrisch isolierte Zonen (32),
c) Aufbringen einer Schicht aus Polyimid (34) auf eine Fläche dieser metallischen Zonen,
d) Beseitigen der Polyimid-Schicht zumindest an den Stellen (36) der metallischen Zonen (32), die für die Ausbildung der elektrischen Verbindungen vorgesehen sind und an der Stelle, wo die elektrische Komponente (35) geklebt werden soll,
e) Aufkleben der elektronischen Komponente (35), die die Ausgangsanschlüsse (37) aufweist, auf die besagte Fläche,
f) elektrisches Verbinden der Ausgangsanschlüsse (37) der elektronischen Komponente (35) mit den metallischen Zonen (32),
g) Einbetten der elektronischen Komponente und der elektrischen Verbindungen (38) mittels eines Harzes,
h) Erhitzen der Anordnung, bestehend aus der Polyimid-Schicht (34) der Metallschicht (22), die die elektronische Komponente (35) und die elektrischen Verbindungen (38) trägt, die in dem Harz eingebettet sind, auf eine erhöhte Temperatur derart, daß ein schnelles Aushärten des Harzes erzielt wird,
i) Plazieren der Anordnung auf den Träger (20) derart, daß die eingekapselte elektronische Komponente in der Ausnehmung (21) liegt.

5. Verfahren nach Anspruch 4, **dadurch gekennzeichnet**, daß dem Arbeitsgang des Plazierens der Anordnung auf einen Träger (20) ein Arbeitsgang des Beseitigens der Polyimid-Schicht (34) ohne Änderung der Verbindungen des Polyimids zwischen den metallischen Zonen (23 bis 31) vorangeht.

6. Verfahren nach einem der vorhergehenden Ansprüche, bei welchem das Polyimid durch Silikon und/oder Epoxidharz ersetzt wird.

## Claims

1. Method for fitting an electronic component (35) and its electrical connections (32, 38) on a support (20) with a cavity (21) for housing the said component, the said method comprising the following sequence of operations:
a) depositing a metallic layer (22) on an operational support such as a board,
b) cutting this metallic layer (22) into regions (32) insulated electrically from each other,
c) depositing on one face of these metallic regions a layer of polyimide (34),
d) bonding to the other face of these metallic regions the electronic component (35) with output terminals (37),
e) electrically connecting these output terminals (37) of the electronic component (35) to the metallic regions (32),
f) coating the electronic component and electrical connections (38) with a resin,
g) heating at high temperature the assembly formed by the layer of polyimide (34), the metallic layer (22) carrying the electronic component (35) and the electrical connections (38) coated with resin, so as rapidly to obtain hardening of the resin,
h) fitting the assembly on the support (20) so that the encapsulated electronic component is housed in the cavity (21).

2. Method according to Claim 1, characterised in that it comprises the following supplementary operation:
i) removing the layer of polyimide (34) so as to leave clear the metallic regions (32) without impairing the polyimide joints between the metallic regions (23 to 29).

3. Method according to Claim 2, characterised in that the operation of removing the polyimide layer (34) is designed to remove also the polyimide joints between the metallic regions (23 to 31).

4. Method for fitting an electronic component (35) and its electrical connections (32, 38) on a support (20) with a cavity (21) for housing the said component, the said method comprising the following sequence of operations:
a) depositing a metallic layer (22) on an operational support such as a board,
b) cutting this metallic layer (22) into regions (32) insulated electrically from each other,
c) depositing on one face of these metallic regions a layer of polyimide (34),
d) removing the polyimide layer at least at those points (36) of the metallic regions (32) designed to provide the electrical connections and at the point where the electrical component (35) is to be bonded,
e) bonding the electronic component (35) with output terminals (37) to the said face,
f) electrically connecting these output terminals (37) of the electronic component (35) to the metallic regions (32),
g) coating the electronic component and electrical connections (38) with a resin,
h) heating at high temperature the assembly formed by the layer of polyimide (34), the metallic layer (22) carrying the electronic component (35) and the electrical connections (38) coated with resin, so as rapidly to obtain hardening of the resin,
i) fitting the assembly on the support (20) so that the encapsulated electronic component is housed in the cavity (21).

5. Method according to Claim 4, characterised in that the operation of fitting the assembly on the support (20) is preceded by an operation of removing the polyimide layer (34) without impairing the polyimide joints between the metallic regions (23 to 31).

6. Method according to any one of the preceding claims, in which the polyimide is replaced by silicone and/or epoxy resin.
